# EUROPÄISCHE PATENTSCHRIFT

(11) **EP 3 109 171 B1**
(45) Veröffentlichungstag und Bekanntmachung des Hinweises auf die Patenterteilung: **21.04.2021**
(21) Anmeldenummer: 15001870.3
(22) Anmeldetag: 24.06.2015
(51) Int. Cl.: B64G 1/10, B64G 1/42, B64G 1/50

(54) **MODULARE SATELLITEN-GERÄTETRÄGERTAFEL**
MODULAR SATELLITE DEVICE SUPPORT PANEL
PANNEAU PORTE-OUTILS MODULAIRE POUR UN SATELLITE

(43) Veröffentlichungstag der Anmeldung: 28.12.2016
(73) Patentinhaber: Airbus Defence and Space GmbH, 82024 Taufkirchen (DE)
(72) Erfinder: Bose, Guido, 88090 Immenstaad (DE); Grasl, Andreas, 83101 Rohrdorf/Thansau (DE)
(74) Vertreter: Frenkel, Matthias Alexander

(56) Entgegenhaltungen:
- EP-A1- 0 776 827
- EP-A1- 0 869 063
- EP-A2- 0 780 295
- EP-A2- 2 014 553
- WO-A2-2012/020960
- FR-A1- 2 898 872

## Beschreibung

### TECHNISCHES GEBIET

Die vorliegende Erfindung betrifft eine modulare Satelliten-Geräteträgertafel zur Aufnahme von elektrischen und/oder elektronischen Baugruppen.

### HINTERGRUND DER ERFINDUNG

Bisher wurden ausnahmslos sämtliche elektrischen und elektronischen Bauelemente, welche die Funktion des Satelliten bestimmen (zum Beispiel Rechner, Regel- und Steuereinheiten, Sensoren, Sender, Empfänger) in zum Teil sehr schweren Elektronikkästen auf den Oberflächen der zentralen Satellitenstrukturen und den Satelliten-Seitenwänden, den Satellitenpanels untergebracht. Ebenso wurde bisher die Verkabelung, die die Elektronikkästen elektrisch miteinander verbindet, auf der Oberfläche der Satellitenstrukturen geführt - zum Teil quer durch den Satelliten um einen Elektronikkasten mit einem anderen Elektronikkasten auf einem anderen Panel elektrisch zu verbinden.

Dies führte zu sehr komplizierten und langen Integrations- und Testphasen, diese Architektur erlaubt keine modulare Flexibilität und ist somit nicht für die Serienfertigung geeignet.

Die elektrischen Hochstromleitungen, die ihre Energie direkt aus den Batterien und Solar-Arrays des Satelliten erhalten und zur Stromregelungseinheit (Power Control Unit - PCU) führen, müssen auch zum Teil über lange Strecken und über Zwischensteckerbrackets geführt werden. Fehler, zumeist Bedienungsfehler, während der Integration in diesem Bereich haben schon zu Kurzschlüssen geführt, die umfangreiche Schäden verursacht haben.

In der konventionellen Satellitentechnik werden die elektrischen und elektronischen Subsysteme, zum Beispiel die Stromversorgungseinheit PCDU (Power Control and Distribution Unit), die ausgelagerte Schnittstelleneinheit RIU (Remote Interface Unit), den Bordcomputer OBC (On-Bord Computer) oder die Sensorik, über Elektronikkästen oder Elektronikboxen maßgeschneidert für jedes neue Satellitensystem neu entwickelt und für jedes Projekt neu gebaut. Dieses Konzept ist für eine Serienproduktion ungeeignet. Diese Elektronikkästen sind meist sehr groß und schwer und daher nur mit Hilfe eines Krans integrierbar. Zudem sind die elektrischen Schnittstellen, wie beispielsweise Stecker, zumeist sehr schwer zugänglich. Es werden zum Beispiel üblicherweise Kabelbäume mit zum Teil 20 verschiedenen Steckertypen und zum Teil 40 Steckern pro Box gebaut, welche manuell sehr zeitaufwändig Stecker für Stecker mit dem Kabelbaum verbunden werden müssen. Die bislang bekannten Elektronikkästen und die umfangreichen Kabelverbindungen wurden ausnahmslos auf der Oberfläche von Satelliten-Panels verbaut. Insbesondere für die elektrische Stromversorgung bilden die elektrischen Kabel und zum Teil mehrere die Kabel miteinander verbindende Stecker Schnittstellen im Hochstrombereich, die eine latente Kurzschluss-Gefahrenquelle darstellen. Die herkömmliche Integration von Satelliten mit derartigen Elektronikkästen und Kabelverbindungen beansprucht am Satelliten-Integrationsplatz viel Zeit für die Integrationstätigkeiten und für die während der Integration durchzuführenden Funktionstests.

### STAND DER TECHNIK

In der nicht vorveröffentlichten Patentanmeldung des Anmelders der vorliegenden Anmeldung (Anmelderaktenzeichen P700975) wird eine Dockingstruktur eines Satelliten zur Ankoppelung von Geräteträgertafeln zur Aufnahme von mit einer Mehrzahl von elektrische und/oder elektronische Baugruppen aufnehmenden Elektronikkästen beschrieben. Diese Elektronikkästen können zwar vorgefertigt und vorgetestet werden, müssen aber am Integrationsarbeitsplatz des Satelliten mit der Geräteträgertafel mechanisch und elektrisch integriert werden.

In der nicht vorveröffentlichten Patentanmeldung des Anmelders der vorliegenden Anmeldung (Anmelderaktenzeichen P700980) wird ein modularer Satellit mit einer Mehrzahl von elektrische und/oder elektronische Baugruppen aufnehmenden Elektronikkästen beschrieben, bei welchem die standardisierten Elektronikkästen in rasterartigen, standardisierten Montageplätzen angebracht und elektrisch kontaktiert werden können.

In der nicht vorveröffentlichten Patentanmeldung des Anmelders der vorliegenden Anmeldung (Anmelderaktenzeichen P700974) wird eine Geräteträgertafel eines Satelliten mit zumindest einem Elektronikkasten, der elektrische und/oder elektronische Baugruppen aufnimmt, beschrieben, wobei eine Grundplatte der Geräteträgertafel zumindest bereichsweise mit Wärmeleiteinrichtungen ausgestattet ist, die ausgestaltet sind, um auf die Grundplatte oder auf einen Bereich der Grundplatte einwirkende Wärme oder Kälte durch Wärmeleitung abzutransportieren.

Dokument FR 2 898 872 A1 lehrt eine Geräteträgertafel mit einer Grundfläche, auf die Installationseinheiten aufgesteckt werden. Die Installationseinheiten werden über Kabel an eine Linientransferschaltung angeschlossen, welche ein Teil der Geräteträgertafel ist.

WO 2012/020960 A2 beschreibt einen multifunktionellen Aufbau zur Verwendung im Weltraum. Ein Gitterrahmen ist mit einer Grundplatte verbunden und dazu ausgebildet, wenigstens eine Leiterplatte zum Durchführen einer elektrischen Funktion aufzunehmen. Die Leiterplatte ist innerhalb eines Gitterfreiraums zwischen dem Gitterrahmen und der Grundplatte vorgesehen und verfügt über eine elektrische Verdrahtung zur Stromversorgung und zur Kommunikation nach außen.

### DARSTELLUNG DER ERFINDUNG

Aufgabe der vorliegenden Erfindung ist es daher, einen modularen Satelliten und insbesondere dessen Geräteträgertafeln so auszugestalten, dass eine noch schnellere Satelliten-Integration auch bei größeren Stückzahlen möglich ist.

Diese Aufgabe wird gelöst durch eine modulare Geräteträgertafel mit den Merkmalen des Anspruchs 1.

Diese erfindungsgemäße modulare Satelliten-Geräteträgertafel zur Aufnahme von elektrischen und/oder elektronischen Baugruppen, weist einen Grundkörper auf, der mit zumindest einer Ausnehmung versehen ist, in die zumindest eine der elektrischen und/oder elektronischen Baugruppen einbaubar ist, wobei der Grundkörper Einrichtungen zur Verteilung von elektrischer Energie zu am Boden der zumindest einen Ausnehmung oder an einer inneren Stirnwand der zumindest einen Ausnehmung, wobei die zumindest eine Ausnehmung nach oben und zu einer Seite offen ist, vorgesehenen elektrischen Energieanschlüssen für die dort vorgesehene zumindest eine elektrische und/oder elektronische Baugruppe aufweist.

### VORTEILE

Die zur Energieversorgung der elektrischen und/oder elektronischen Baugruppen erforderliche Hochstrom-Infrastruktur ist bei der erfindungsgemäßen modularen Satelliten-Geräteträgertafel in deren Grundkörper integriert, so dass auf der Geräteträgertafel keine Verkabelung dafür vorgesehen sein muss. Zudem sind die elektrischen und/oder elektronischen Baugruppen in eigenen Ausnehmungen des Grundkörpers aufgenommen, wo auch die Kontaktierung mit der Hochstrom-Infrastruktur erfolgt. Dadurch ist das Kurzschlussrisiko deutlich herabgesetzt. Aufgrund der Anordnung der elektrischen und/oder elektronischen Baugruppen in Ausnehmungen des Grundkörpers kann auf das Vorsehen von Elektronikkästen als Umhüllung für die elektrischen und/oder elektronischen Baugruppen verzichtet werden, was zur Gewichtsreduzierung beiträgt und was es gleichzeitig ermöglicht, die gesamte Satelliten-Geräteträgertafel an einem separaten IntegrationsArbeitsplatz vorzufertigen und zu testen, so dass am Satelliten-Integrationsplatz nur noch fertig bestückte und getestete Geräteträgertafeln in den Satelliten eingebaut werden müssen. Die zeitliche Inanspruchnahme eines Satelliten-Integrationsplatzes sinkt damit beträchtlich, wodurch eine Serienfertigung von Satelliten deutlich wirtschaftlicher durchgeführt werden kann.

In Bereichen von Satelliten-Geräteträgertafeln in Satellitenstrukturen, die von der Oberfläche her zugänglich sind, sind Ausnehmungen eingearbeitet, die elektrische und/oder elektronische Baugruppen und gegebenenfalls Batterien aufnehmen. Der Hochstromteil der Stromversorgung, also die Einrichtungen zur Verteilung von elektrischer Energie, der Satelliten-Geräteträgertafel weist weniger Stecker-Schnittstellen auf als im Stand der Technik und stattdessen eine direkte Verbindung innerhalb des Panels als eingebettete Verbindung, was die Kurzschlussgefahr bei der Integration nahezu unmöglich macht.

Weitere bevorzugte und vorteilhafte Ausgestaltungsmerkmale der erfindungsgemäßen modularen Satelliten-Geräteträgertafel sind Gegenstand der Unteransprüche 2 bis 15.

Vorzugsweise bilden die Einrichtungen zur Verteilung von elektrischer Energie zumindest einen Energiebus aus.

Besonders bevorzugt ist eine Ausführungsform, bei der der Grundkörper zumindest einen Deckel zur Abdeckung der zumindest einen Ausnehmung aufweist.

Bevorzugter Weise ist der Grundkörper mit Signal- und/oder Datenübertragungsmitteln versehen, die im Bereich der zumindest einen Ausnehmung vorgesehene Signal- und/oder Datenübertragungsanschlüsse aufweisen. Dabei ist es besonders vorteilhaft, wenn die Signal- und/oder Datenübertragungsmittel elektrisch leitende Verbindungen aufweisen.

Auch vorteilhaft ist es, wenn die Signal- und/oder Datenübertragungsmittel optische Lichtleiterverbindungen aufweisen. Datenübertragungsverbindungen zwischen den einzelnen in den Grundkörper eingebetteten Komponenten untereinander oder mit anderen Komponenten des Satelliten können vorzugsweise auch drahtlos ausgestaltet sein, wie beispielsweise mittels eines satelliteninternen WLAN.

Bevorzugt ist eine Variante, bei der die Signal- und/oder Datenübertragungsmittel zumindest einen Datenbus aufweisen.

Vorteilhafterweise ist der Datenbus als drahtloser Datenbus ausgebildet, über den in die zumindest eine Ausnehmung eingesetzte Baugruppen miteinander oder mit einer zentralen Satelliteninfrastruktur kommunizieren.

Der Grundkörper kann auch mit eingebetteten Kabeln und/oder Hochfrequenzleitungen, wie beispielsweise Koaxialleitungen oder Wave-Guides ausgestattet sein, welche ihre HF-Energie zwischen eingebetteten HF-Elektronik-Kästen und an der Außenseite angebrachten HF-Antennen leiten.

Eine weitere vorteilhafte Ausführungsform zeichnet sich dadurch aus, dass zumindest eine der in die Ausnehmungen des Grundkörpers einsetzbaren oder eingesetzten elektrischen und/oder elektronischen Baugruppen von Hochfrequenz-Elektronikkästen gebildet ist, dass Hochfrequenz-Koaxialkabel und/oder Hochfrequenz-Wellenleiter zumindest teilweise in den Grundkörper eingebettet sind und dass die Hochfrequenz-Elektronikkästen über die Hochfrequenz-Koaxialkabel und/oder die Hochfrequenz-Wellenleiter zur Kommunikation mit entsprechenden Hochfrequenzkomponenten einer zentralen Satelliteninfrastruktur verbindbar sind.

Auch kann es von Vorteil sein, wenn im Grundkörper weiterhin elektrische Elemente, wie zum Beispiel Balance-Widerstände, Schalter, Sensoren, insbesondere Hall-Sensoren, Stecker und/oder Dehnungsmessstreifen eingebettet vorgesehen sind, die mit Steuer-, Versorgungs- und/oder Signalleitungen der Satelliteninfrastruktur verbindbar oder verbunden sind.

Vorteilhaft ist es, wenn die Einrichtungen zur Verteilung von elektrischer Energie, Einrichtungen zum Transport von Hochfrequenzenergie und/oder andere elektrische Versorgungsleitungen, Steuerleitungen und Signalleitungen sowie gegebenenfalls elektrische Datenübertragungsleitungen und vorzugsweise auch Heizeinrichtungen und/oder Microcontroller auf oder in zumindest einer, vorzugsweise flexiblen, Platine vorgesehen sind, die in den Grundkörper eingebettet oder auf dem Grundkörper vorgesehen ist.

Bei einer anderen vorteilhaften Weiterbildung ist im Deckel eine, vorzugsweise flexible, Platine vorgesehen, die Einrichtungen zur Verteilung von elektrischer Energie, Einrichtungen zum Transport von Hochfrequenzenergie und/oder andere elektrische Versorgungsleitungen, Steuerleitungen und Signalleitungen sowie gegebenenfalls elektrische Datenübertragungsleitungen und vorzugsweise auch Heizeinrichtungen und/oder Microcontroller aufweist.

Dabei ist es von Vorteil, wenn der Grundkörper zumindest bereichsweise mit Wärmeleiteinrichtungen ausgestattet ist, die ausgestaltet sind, um auf den Grundkörper oder auf einen Bereich des Grundkörpers einwirkende Wärme oder Kälte durch Wärmeleitung abzutransportieren.

Dabei ist es besonders sinnvoll, wenn die Wärmeleiteinrichtungen Heatpipes aufweisen, die an oder in dem Grundkörper vorgesehen sind.

Insbesondere ist es dabei von Vorteil, wenn die Heatpipes von im Inneren des Grundkörper verlaufenden Bahnen aus einem wärmeleitenden Material, vorzugsweise aus einem Metall, oder von im Inneren des Grundkörpers verlaufenden Kanälen aus einem wärmeleitenden Material, vorzugsweise aus einem Metall, gebildet sind, die von einem Wärmetransportmedium durchströmt oder durchströmbar sind.

Bevorzugte Ausführungsbeispiele der Erfindung mit zusätzlichen Ausgestaltungsdetails und weiteren Vorteilen sind nachfolgend unter Bezugnahme auf die beigefügten Zeichnungen näher beschrieben und erläutert.

### KURZE BESCHREIBUNG DER ZEICHNUNGEN

Es zeigt:
- Fig. 1: eine perspektivische schematische Ansicht von zwei miteinander verbundenen erfindungsgemäßen Satelliten-Geräteträgertafeln;
- Fig. 2: einen ersten Hochstromblock zur Integration in eine Geräteträgertafel aus Fig. 1;
- Fig. 3: einen zweiten Hochstromblock zur Integration in eine Geräteträgertafel aus Fig. 1,
- Fig. 4: einen dritten Hochstromblock zur Integration in eine Geräteträgertafel aus Fig. 1
- Fig. 5: eine alternative Ausführungsform der Satelliten-Geräteträgertafel-Anordnung aus Fig. 1 und
- Fig. 6: einen ersten Hochfrequenzblock zur Integration in eine Geräteträgertafel aus Fig. 5.

### DARSTELLUNG VON BEVORZUGTEN AUSFÜHRUNGSBEISPIELEN

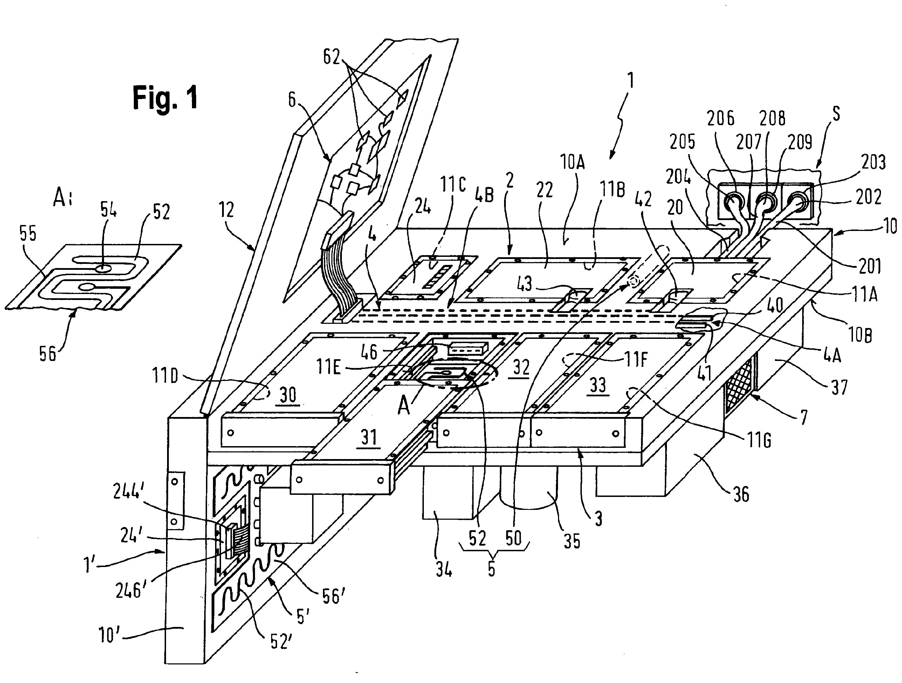

Fig. 1 zeigt in perspektivischer Ansicht eine geöffnete Satelliten-Geräteträgetafel 1 gemäß der vorliegenden Erfindung, die mit einer gleichartig oder ähnlich aufgebauten Satelliten-Geräteträgertafel 1' verbunden ist. Es wird nachstehend zur Vermeidung von Wiederholungen lediglich die Geräteträgertafel 1 beschrieben, da die zweite Geräteträgertafel 1' gleichartige Merkmale aufweist.

Die Satelliten-Geräteträgertafel 1 weist einen Grundkörper 10 auf, der auf einer ersten Seite 10A mit einer Mehrzahl von Ausnehmungen 11A, 11B, 11C, 11D, 11E, 11F, 11G versehen ist. Die mit den Ausnehmungen 11A, 11B, 11C, 11D, 11E, 11F, 11G versehene erste Seite 10A (in Fig. 1 die Oberseite) des Grundkörpers 10 ist mit einem Deckel 12 verschließbar, der beispielsweise gelenkig schwenkbar oder abnehmbar am Grundkörper 10 angebracht ist.

Der Grundkörper 10 enthält Einrichtungen 4 zur Verteilung von elektrischer Energie, die Hochstrom-Leiter 40, 41 aufweisen, welche im Inneren des Grundkörpers 10 geschützt vorgesehen sind. Eine erste Gruppe von Ausnehmungen 11A, 11B, 11C nimmt elektrische und/oder elektronische Baugruppen 2 der Stromverteilungsinfrastruktur auf, die Hochstromblöcke 20, 22, 24 umfassen. Die weiteren Ausnehmungen 11D, 11E, 11F, 11G sind zur Aufnahme von weiteren elektrischen und/oder elektronischen Baugruppen 3 ausgebildet, die weiter unten noch im Einzelnen beschrieben werden. Die Einrichtungen 4 zur Verteilung von elektrischer Energie bilden so im Grundkörper 10 einen Hochstrom-Energiebus 4A für die elektrische Hochstromverteilung von und zu den elektrischen und/oder elektronischen Baugruppen 2, 3 aus. Weiterhin umfassen die Einrichtungen 4 zur Verteilung von elektrischer Energie einen Niederstrom-Energiebus 4B für die elektrische Niederstromverteilung von und zu den elektrischen und/oder elektronischen Baugruppen 2, 3.

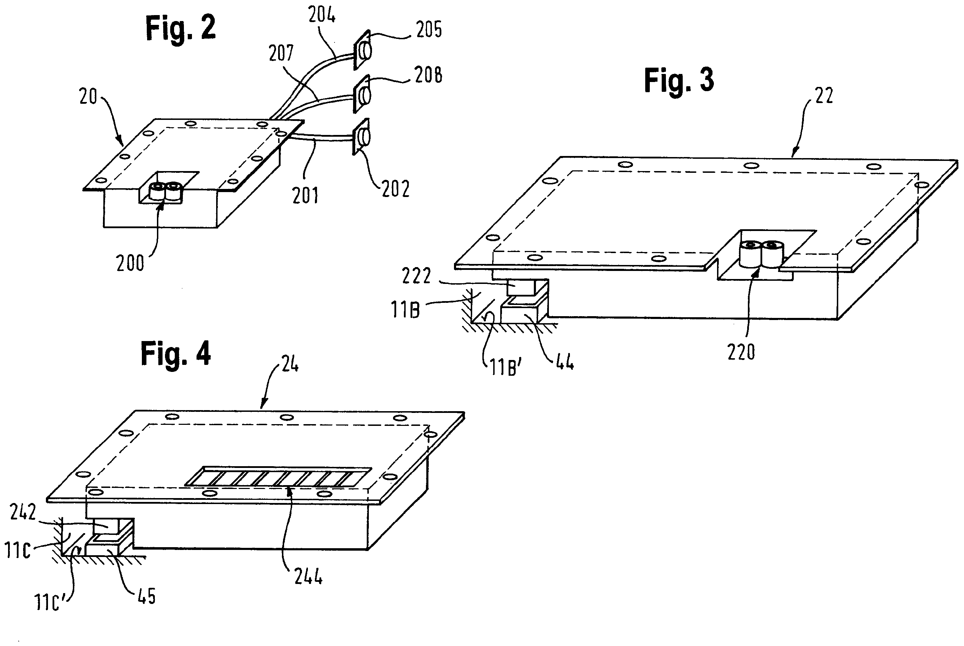

In einer ersten Ausnehmung 11A ist ein erster Hochstromblock 20 vorgesehen, der in die Ausnehmung 11A eingesetzt und darin mittels allgemein bekannter Befestigungsmittel (zum Beispiel Schrauben) mechanisch befestigt ist. Dieser erste Hochstromblock 20 ist, herausgelöst aus dem Grundkörper 10, in Fig. 2 im Einzelnen dargestellt.

Der erste Hochstromblock 20 ist mit einer Hochstrom-Steckverbindung 200 versehen, die mittels einer ersten Hochstrom-Verbindungseinrichtung 42 mit den Hochstromleitern 40, 41 elektrisch verbindbar ist. Des Weiteren ist der erste Hochstromblock 20 mit einem Solar-Array-Anschlusskabel 201 versehen, das an seinem freien Ende einen elektrischen Stecker 202 aufweist, der mit einem in der Satelliten-Infrastruktur vorgesehenen Gegenstecker 203 eines Solar-Stromversorgungskabels des Satelliten S verbindbar und, wie in Fig. 1 gezeigt ist, verbunden ist. Der ersten Hochstromblock 20 ist weiterhin mit einem Batteriekabel 204 versehen, das an seinem freien Ende einen Batteriestecker 205 aufweist, der mit einem in der Infrastruktur des Satelliten S vorgesehenen Gegenstecker 206 einer Batteriestromleitung verbindbar und im Beispiel der Fig. 1 verbunden ist. Schließlich weist der erste Hochstromblock 20 noch ein Umbilicalkabel 207 auf, das mit einem Umbilicalstecker 208 versehen ist, der mit einem Umbilikal-Gegenstecker 209 der Infrastruktur des Satelliten S und einem mit diesem verbundenen Satelliten-Umbilicalkabel verbindbar und im gezeigten Beispiel der Fig. 1 verbunden ist. Auf diese Weise kann Batteriestrom und Solarstrom von außen durch den ersten Hochstromblock 20 zu den Hochstromleitern 40, 41 geleitet werden.

Der erste Hochstromblock 20 dient zur Anpassung und Absicherung von in die Satelliten-Geräteträgertafel 1 eingeleiteter elektrischer Energie, die aus unterschiedlichen Quellen (zum Beispiel Solar-Array oder externe Batterien) zugeführt wird. Im ersten Hochstromblock 20 sind dazu beispielsweise ein Solar-Array-Konverter, Gleichrichter, Leistungsdioden, Batterierelais, Amperemeter, Balancingwiderstände sowie weitere Komponenten zur Spannungs- und/oder Stromregelung vorgesehen. Auch elektrische Sicherungen zur Absicherung der in der Satelliten-Geräteträgertafel 1 vorgesehenen elektrischen und/oder elektronischen Baugruppen 2, 3 sind im ersten Hochstromblock 20 enthalten.

Ein zweiter Hochstromblock 22 ist in die zum ersten Hochstromblock 20 benachbarte Ausnehmung 11B eingebettet. Der zweite Hochstromblock 22 ist ebenfalls mit einer Hochstrom-Steckverbindung 220 versehen, die mittels einer zweiten Hochstrom-Verbindungseinrichtung 43 mit den Hochstromleitern 40, 41 elektrisch verbindbar ist. Wie in Fig. 3 zu erkennen ist, ist der zweite Hochstromblock 22 mit einem Ausgangsstecker 222 versehen, der nach unten zum Boden 11B' der Ausnehmung 11B weist. Dort am Boden 11B' ist ein elektrischer Gegenstecker 44 vorgesehen, der mit dem im Inneren des Grundkörpers 10 geschützt vorgesehenen Niederstrom-Energiebus elektrisch verbunden ist.

Beim Einsetzen des zweiten Hochstromblocks 22 in die Ausnehmung 11B wird eine elektrisch leitende Steckverbindung zwischen dem Stecker 222 und dem Gegenstecker 44 hergestellt, so dass der Niederstrom-Energiebus 4B vom zweiten Hochstromblock 22 mit elektrischer Energie versorgt wird. Auf diese Weise können beispielsweise unterschiedliche elektrische Spannungen mit unterschiedlich begrenzten elektrischen Strömen in den Niederstrom-Energiebus 4B eingeleitet werden. Auch Datenaustauschverbindungen zwischen dem zweiten Hochstromblock 22 und einem im Grundkörper 10 vorgesehenen (nicht gezeigten) zentralen Datenbus können über diese Steckverbindung herstellbar sein.

Der zweite Hochstromblock 22 weist beispielsweise Mittel zur elektrischen Spannungswandlung und zur elektrischen Strombegrenzung auf, die von einem integrierten Computer gesteuert werden. Diese Mittel können beispielsweise elektronische Ein-Aus-Schalter mit Strombegrenzung (Line Current Limiter - LCL oder Foldback-Current-Limiter FCL) aufweisen. Derartige LCLs und FCLs sind erprobte und ausgereifte elektronische Schalter, die sich in der Satellitentechnik bewährt haben.

Eine dem zweiten Hochstromblock 22 benachbarte Ausnehmung 11C nimmt einen dritten Hochstromblock 24 auf, der die Stromversorgung und Steuerung von im Inneren des Grundkörpers 10 vorgesehenen Thermokontrolleinrichtungen 5 für die Temperaturkontrolle der Satelliten-Geräteträgertafel 1 enthält.

Diese Thermokontrolleinrichtungen 5 umfassen beispielsweise in Fig. 1 nur schematisch dargestellte Wärmeleiteinrichtungen 50, die ausgestaltet sind, um auf den Grundkörper 10 oder auf einen Bereich des Grundkörpers 10 einwirkende Wärme oder Kälte durch Wärmeleitung abzutransportieren. Die Thermokontrolleinrichtungen 5 können - zusätzlich oder alternativ - auch elektrische Kühl- und/oder Heizeinrichtungen 52 aufweisen, die ausgebildet sind, um den Grundkörper 10 oder einen Bereich des Grundkörpers 10 unmittelbar zu kühlen oder zu erwärmen. Den Wärmeleiteinrichtungen 50 und/oder den Kühl- und/oder Heizeinrichtungen 52 ist jeweils zumindest ein in dem vergrößerten Ausschnitt der Fig. 1 gezeigter Temperatursensor 54 zugeordnet, der in oder auf dem Grundkörper 10 angeordnet ist. Im Falle von elektrischen Kühl- und/oder Heizeinrichtungen 52 können diese zusammen mit ihren elektrischen Versorgungs- und Steuerleitungen und gegebenenfalls auch den ihnen zugeordneten Temperatursensoren 54 und deren Versorgungs- und Signalleitungen 55 in oder auf zumindest einer vorzugsweise flexiblen Platine 56 vorgesehen sein, die in den Grundkörper 10 eingebettet ist. Durch diese Einbettung ist die gesamte Infrastruktur der Thermokontrolle, also die Thermokontrolleinrichtungen 5 und der dritte Hochstromblock 24, für die Satelliten-Geräteträgertafel 1 geschützt im Inneren des Grundkörpers 10 aufgenommen.

Der in Fig. 4 als Einzelheit dargestellte dritte Hochstromblock 24 ist - wie der zweite Hochstromblock 22 - an seiner zum Boden 11C' der Ausnehmung 11C weisenden Seite mit einem kombinierten Stromversorgungs- und Datenstecker 242 versehen, der mit einem Gegenstecker 45 am Boden 11C' der Ausnehmung 11C beim Einführen des dritten Hochstromblocks 24 in die Ausnehmung 11C elektrisch und mechanisch kuppelbar ist. Über diese aus dem Stecker 242 und dem Gegenstecker 45 gebildete elektrische Steckverbindung wird der dritte Hochstromblock 24 mit elektrischer Energie versorgt. Auch Datenaustauschverbindungen zwischen dem dritten Hochstromblock 24 und dem im Grundkörper 10 vorgesehenen zentralen Datenbus können über diese Steckverbindung herstellbar sein.

An seiner im in den Grundkörper 10 eingebauten Zustand zum Deckel 12 weisenden Oberseite ist der dritte Hochstromblock 24 mit einer elektrischen Steckeraufnahme 244 versehen, in die ein Stecker, beispielsweise der flexiblen Platine, zur Versorgung der elektrischen Kühl- und/oder Heizeinrichtungen 52 sowie zum Anschluss von Steuereinrichtungen der Wärmeleiteinrichtungen 50 und zum Anschluss der Temperatursensoren einsteckbar ist.

In Fig. 1 ist weiterhin zu sehen, dass in die zweite Geräteträgertafel 1' ebenfalls eine solche Thermokontrolleinrichtung 5' eingebettet ist, welche eine flexible Platine 56' aufweist. Der Deckel der zweiten Geräteträgertafel 1' ist in Fig. 1 nicht zu erkennen, obwohl ein solcher Deckel vorgesehen ist, um die sichtbare offene Seite des Grundkörpers 10' der zweiten Geräteträgertafel 1' abzudecken. Auf oder in der flexiblen Platine 56' sind elektrische Heizeinrichtungen 52' leiterbahnartig vorgesehen, die von einer dem dritten Hochstromblock 24 entsprechenden Stromversorgungseinrichtung 24' über ein in deren elektrische Steckeraufnahme 244' eingestecktes Flachkabel 246', das von einem Teil der flexiblen Platine 56' gebildet ist, mit elektrischer Energie versorgt werden. Die auch hier vorgesehenen Temperatursensoren sind nicht dargestellt.

Die weiteren Ausnehmungen 11D, 11E, 11F, 11G sind, wie in Fig. 1 zu erkennen ist, nach oben und zu einer Seite offen und sind an zwei einander gegenübergelegenen Seiten mit Schubladenschienen versehen, so dass in jede der Ausnehmungen 11D, 11E, 11F und 11G ein zugeordneter Elektronikkasten 30, 31, 32, 33 schubladenartig einschiebbar ist. Die Elektronikkästen 30, 31, 32, 33 bilden oder enthalten die zweiten elektronischen Baugruppen 3.

An ihrer jeweiligen Rückseite sind die schubladenartigen Elektronikkästen 30, 31, 32, 33 mit zumindest einem (nicht gezeigten) Stecker versehen, der mit zumindest einem zugeordneten Gegenstecker an einer inneren Stirnwand der entsprechenden Ausnehmung 11D, 11E, 11F, 11G elektrisch und mechanisch kuppelbar ist; beispielhaft ist hier nur ein Gegenstecker 46 in der Ausnehmung 11E gezeigt, der zur Verbindung mit dem Elektronikkasten 31 vorgesehen ist. Durch diese Steckverbindungen, die an den Niederstrom-Energiebus 4B und gegebenenfalls an den (nicht gezeigten) Datenbus des Grundkörpers 10 angeschlossen sind, wird der zugeordnete Elektronikkasten (hier der Elektronikkasten 31) mit elektrischer Energie versorgt und kann gegebenenfalls über diese Steckverbindung auch Daten mit dem Datenbus austauschen.

In Fig. 1 ist auch zu erkennen, dass die Satelliten-Geräterträgertafel 1 auf der von der ersten Seite 10A abgewandten Seite 10B (in Fig. 1 der Unterseite) des Grundkörpers 10 weitere externe Elektronikkästen 34, 35, 36, 37 aufnimmt, die nicht in den Grundkörper 10 eingebettet sind, sondern die mechanisch auf der Unterseite des Grundkörpers 10 gehaltert und an einer dort vorgesehenen Docking-Struktur 7 elektrisch angekoppelt sind.

Weiterhin ist in Fig. 1 zu erkennen, dass im Deckel 12 eine, vorzugsweise flexible, Thermokontrollplatine 6 vorgesehen ist, die in den Deckel 12 integriert ist. Auch diese Thermokontrollplatine 6 kann mit elektrischen Kühl- und/oder Heizeinrichtungen 62 sowie deren elektrischen Versorgung- und Steuerleitungen und gegebenenfalls auch Temperatursensoren und deren Signalleitungen versehen sein.

Der Deckel 12 kann außerdem auch nicht-elektrische Wärmeleiteinrichtungen sowie deren Steuer- und Regeleinrichtungen aufweisen. Ist der Deckel 12 geschlossen und liegt somit auf der in Fig. 1 sichtbaren Oberseite des Grundkörpers 10 auf, so kann mittels der im Deckel 12 angeordneten Thermokontrolleinrichtungen Wärme von den in den Grundkörper 10 eingebetteten elektrischen und/oder elektronischen Baugruppen 2, 3 gezielt abgeführt oder bei Bedarf zu diesen hingeführt werden.

Die erfindungsgemäßen Satelliten-Geräteträgertafeln 1, 1' sind in Bereichen von Satellitenstrukturen angeordnet, welche von der Außenseite der jeweiligen Satellitenstruktur zugänglich sind.

Der Einbau der elektrischen und/oder elektronischen Baugruppen, insbesondere der Hochstromblöcke und der weiteren Elektronikkästen, in die Ausnehmungen des Grundkörpers erfolgt vorzugsweise mittels Dämpfungseinrichtungen, um die bei einer Weltraummission, insbesondere beim Start auftretenden Schwingungen abzupuffern. Die eingebetteten elektrischen und/oder elektronischen Baugruppen, bestehen, wie bei Weltraum Missionen üblich, aus strahlengehärteten Elektronik-Elementen.

Die Hochstrom-Leiter 40, 41 sind von Spannungsschienen gebildet, welche im Inneren des Grundkörpers 10 verlaufen und mit den Solar-Arrays und Batterien des Satelliten gekoppelt sind. Bisher wurden die Stromversorgungsleitungen welche direkt mit Solar-Array und Batterien verbunden sind, im Standardkabelbaum des Satelliten und über Zwischenstecker geführt, was schon in der Vergangenheit während Integrationsarbeiten zu schweren Kurzschlüssen mit hohem Materialschaden geführt hat. Die Hochstrom-Spannungsschienen sind innerhalb der Struktur der Geräteträgertafel verbaut. Eine Elektrische Verbindung mit diesen "Mainbus"-Hochstromspannungsschienen ist vorzugsweise nur mit kurzen aus dem Grundkörper ragenden Anschlusskabeln mit sicheren Hochstrom-Steckern möglich sein, damit die Hochstromblocks 20, 22, 24 damit verbunden werden können. Durch diesen geschützten Einbau der Hochstromverteilung und dadurch dass Solar-Array-Regler, Leistungsschutz-Dioden, Batterie-Sicherheits-Relais, Schutz-Widerstände usw. im ersten Hochstromblock 20 gekapselt vorgesehen sind, ist die Kurzschlussgefahr bei der Integration und der Handhabung weitestgehend ausgeschlossen.

Die Gehäuse der eingebetteten elektrischen und/oder elektronischen Baugruppen sind beispielsweise mit Aluminium oder Tantal metallisiert und bilden so einen Abschirmungs-Schutze, um die elektrischen und/oder elektronischen Baugruppen sowohl vor elektromagnetischen Wellen als auch vor Weltraumstrahlung abzuschirmen.

Das hier beschriebene Beispiel eines modularen Geräteträgertafel gestattet es, verschiedene Integrations-Systeme gleichzeitig zu verwenden oder zu kombinieren: Wenn auf der ersten Seite des Grundkörpers die eingebettete ("embedded") Technologie mit Einschubsystem oder Hochstrom Blöcken verwendet wird (wie beschrieben) kann die davon abgewandte Seite mit konventionell montierten Elektronik-Kästen und konventionellen Kabelbäumen verbaut werden.

Die erfindungsgemäße Lösung stellt sicher, dass der Hochstrom Teil des Satelliten-Hochstromsystems weniger Stecker-Schnittstellen beinhaltet und stattdessen die direkte Verbindung vom Hochstrom-Bus zum ersten Hochstromblock und zum zweiten Hochstromblock innerhalb der Geräteträgertafel als eingebettete Verbindung die Kurzschlussgefahr bei der Integration nahezu unmöglich macht.

Der Thermalteil der Geräteträgertafel weist mit den eingebetteten Thermokontrolleinrichtungen, insbesondere mit den als flexible Platine ausgebildeten Kühl- und/oder Heizeinrichtungen nur einem Bruchteil der herkömmlich dafür vorgesehenen Verkabelung auf und macht die Auslegung der Thermokontrolleinrichtungen um ein Vielfaches flexibler.

Der modulare Aufbau der Geräteträgertafel und des gesamten Satelliten ermöglicht die Zusammenfassung von zwei bislang getrennten Fertigungspfaden. Es werden nämlich die Fertigung der Satelliten-Geräteträgertafeln und die Fertigung der Elektronikkästen in einen einzigen Fertigungsschritt- der "embedded Panel Fertigung" zusammengeführt. Die Geräteträgertafel übernimmt die Funktionen des Metallgehäuses, welches in der konventionellen Satellitenfertigung die Elektronik-Platinen und andere Elektronik-Träger umhüllt und schützt. Da der Elektronikkasten-Fertigungspfad wegfällt, kann die Satellitenfertigung effizienter und schneller erfolgen.

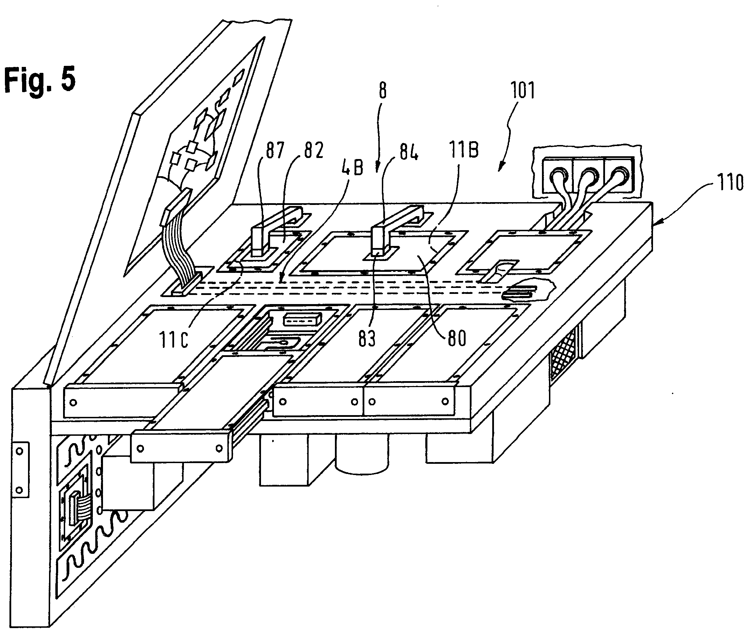

Fig. 5 zeigt eine Anordnung ähnlich der in Fig. 1 gezeigten Anordnung mit einer abgewandelten modularen Satelliten-Geräteträgertafel 101, die im Grundsatz wie die Geräteträgertafel 1 aufgebaut ist. Es werden daher nur die abweichenden Merkmale nachstehend beschrieben.

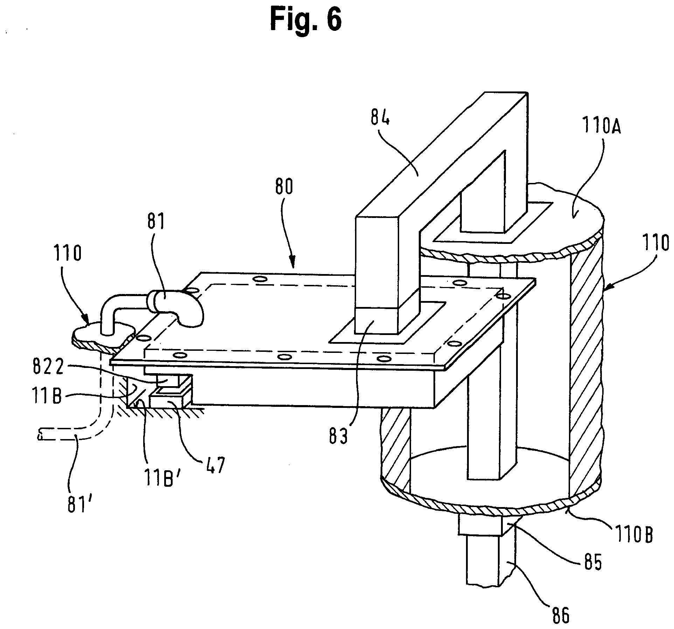

In den Ausnehmungen 11B und 11C ist jeweils ein als Hochfrequenzblock 80, 82 (HF-Block) ausgebildeter Hochfrequenz-Elektronikkasten einer elektrischen und/oder elektronischen Hochfrequenz-Baugruppe 8 eingebettet. Beispielhaft ist der Hochfrequenzblock 80 in Fig. 6 dargestellt; der Hochfrequenzblock 82 ist in analoger Weise aufgebaut. Der Hochfrequenzblock 80 ist mit einem Ausgangsstecker 822 versehen, der nach unten zum Boden 11B' der Ausnehmung 11B weist. Dort am Boden 11B' ist eine elektrischer Gegenstecker 47 vorgesehen, der mit dem im Inneren des Grundkörpers 110 geschützt vorgesehenen Niederstrom-Energiebus 4B elektrisch verbunden ist.

Beim Einsetzen des Hochfrequenzblocks 80 in die Ausnehmung 11B wird eine elektrisch leitende Steckverbindung zwischen dem Stecker 822 und dem Gegenstecker 47 hergestellt, so dass der Hochfrequenzblock 80 vom Niederstrom-Energiebus 4B mit elektrischer Energie versorgt wird. Auch Datenaustauschverbindungen zwischen dem Hochfrequenzblock 80 und dem im Grundkörper 110 vorgesehenen (nicht gezeigten) zentralen Datenbus können über diese Steckverbindung herstellbar sein.

Der Hochfrequenzblock 80 ist mit einem HF-Koaxialanschluss 81 versehen, der mit einem überwiegend im Grundkörper 110 verlaufenden HF-Koaxialkabel 81' verbindbar ist, wie in Fig. 5 schematisch dargestellt ist. Auf der Oberseite ist der Hochfrequenzblock 80 mit einem HF-Hohlleiteranschluss 83 versehen, der mit einem auch als Hochfrequenz-Wellenleiter oder Wave-Guide bezeichneten Hohlleiter 84 verbindbar und, wie in den Figuren gezeigt, verbunden ist. Der Hohlleiter 84 ist im gezeigten Beispiel zu einem Randbereich des Grundkörpers 110 geführt, wo er durch den Grundkörper 110 von der oberen Seite 110A zur unteren Seite 110B hindurchgeführt ist und mittels einer HF-Steckverbindung 85 an einen beispielsweise zu einer Antenne führenden Hochfrequenz-Wellenleiter 86 angeschlossen ist. In äquivalenter Weise ist auch der zweite Hochfrequenzblock 82 über einen durch den Grundkörper 110 hindurch verlaufenden Hohlleiter 87 und mittels einer entsprechenden HF-Steckverbindung mit einem weiteren externen Hochfrequenz-Wellenleiter verbunden.

Eingebettete Elektronikkästen gemäß Fig. 5 können zum Beispiel RX/TX-Receiver oder -Transmitter, Mischer und/oder Decoder mit Ankopplungs-Schnittstellen für Hochfrequenz-Wellenleiter (zum Beispiel Hohlleiter) und/oder Koaxialleitungen sein. In der unmittelbaren Nachbarschaft von Hochstromkästen und HF-Elektronikkästen sollten Headpipes liegen um die erhöhte Wärme abführen zu können.

Bezugszeichen in den Ansprüchen, der Beschreibung und den Zeichnungen dienen lediglich dem besseren Verständnis der Erfindung und sollen den Schutzumfang nicht einschränken.

### Bezugszeichenliste

Es bezeichnen:
- 1, 1': Satelliten-Geräteträgertafel
- 2: elektrische und/oder elektronische Baugruppe
- 3: elektrische und/oder elektronische Baugruppe
- 4: Einrichtung zur Verteilung von elektrischer Energie
- 4A: Hochstrom-Energiebus
- 4B: Niederstrom-Energiebus
- 5, 5': Thermokontrolleinrichtung
- 6: Thermokontrollplatine
- 7: Dockingstruktur
- 8: HF-Baugruppe
- 10, 10': Grundkörper
- 10A: erste Seite
- 10B: zweite Seite
- 11A: Ausnehmung
- 11B: Ausnehmung
- 11B': Boden der Ausnehmung 11B
- 11C: Ausnehmung
- 11C': Boden der Ausnehmung 11C
- 11D: Ausnehmung
- 11E: Ausnehmung
- 11F: Ausnehmung
- 11G: Ausnehmung
- 12: Deckel
- 20: erster Hochstromblock
- 22: zweiter Hochstromblock
- 24, 24': dritter Hochstromblock
- 30: eingebetteter Elektronikkasten
- 31: eingebetteter Elektronikkasten
- 32: eingebetteter Elektronikkasten
- 33: eingebetteter Elektronikkasten
- 34: Elektronikkasten
- 35: Elektronikkasten
- 36: Elektronikkasten
- 37: Elektronikkasten
- 40: Hochstrom-Leiter
- 41: Hochstrom-Leiter
- 42: erste Hochstrom-Verbindungseinrichtung
- 43: zweite Hochstrom-Verbindungseinrichtung
- 44: Gegenstecker
- 45: Gegenstecker
- 46: Gegenstecker
- 47: Gegenstecker
- 50: Wärmeleiteinrichtung
- 52, 52': Kühl- und/oder Heizeinrichtungen
- 54: Temperatursensor
- 55: Versorgungs- und Signalleitungen
- 56, 56': Platine
- 62: Kühl- und/oder Heizeinrichtungen
- 80: Hochfrequenzblock
- 81: HF-Koaxialanschluss
- 81': HF-Koaxialkabel
- 82: Hochfrequenzblock
- 83: HF-Hohlleiteranschluss
- 84: Hohlleiter
- 85: HF-Steckverbindung
- 86: Wellenleiter
- 87: Hohlleiter
- 101: Satelliten-Geräteträgertafel
- 110: Grundkörper
- 110A: obere Seite des Grundkörpers
- 110B: untere Seite des Grundkörpers
- 200: Hochstrom-Steckverbindung
- 201: Solar-Array-Anschlusskabel
- 202: elektrischer Stecker
- 203: Stecker eines Solar-Stromversorgungskabels
- 204: Batteriekabel
- 205: Batteriestecker
- 206: Gegenstecker
- 207: Umbilicalkabel
- 208: Umbilicalstecker
- 209: Umbilical-Gegenstecker
- 220: Hochstrom-Steckverbindung
- 222: Ausgangsstecker
- 242: kombinierter Stromversorgungs- und Datenstecker
- 244, 244': elektrische Steckeraufnahme
- 246': Flachkabel
- 822: Ausgangsstecker
- S: Satellit

## Patentansprüche

1. Modulare Satelliten-Geräteträgertafel (1) zur Aufnahme von elektrischen und/oder elektronischen Baugruppen (2, 3, 8),
**dadurch gekennzeichnet,**
- **dass** die Satelliten-Geräteträgertafel (1) einen Grundkörper (10) aufweist, der mit zumindest einer Ausnehmung (11A, 11B, 11C, 11D, 11E, 11F, 11G) versehen ist, in die zumindest eine der elektrischen und/oder elektronischen Baugruppen (2, 3, 8) einbaubar ist, und
- **dass** der Grundkörper (10) Einrichtungen (4) zur Verteilung von elektrischer Energie zu am Boden der zumindest einen Ausnehmung (11A, 11B, 11C) oder an einer inneren Stirnwand der zumindest einen Ausnehmung (11D, 11E, 11F, 11G), wobei die zumindest eine Ausnehmung (11D, 11E, 11F, 11G) nach oben und zu einer Seite offen ist, vorgesehenen elektrischen Energieanschlüssen für die dort vorgesehene zumindest eine elektrische und/oder elektronische Baugruppe (2, 3, 8) aufweist.

2. Modulare Satelliten-Geräteträgertafel nach Anspruch 1,
**dadurch gekennzeichnet,**
**dass** die Einrichtungen (4) zur Verteilung von elektrischer Energie zumindest einen Energiebus (4A, 4B) ausbilden.

3. Modulare Satelliten-Geräteträgertafel nach Anspruch 1 oder 2,
**dadurch gekennzeichnet,**
**dass** der Grundkörper (10) zumindest einen Deckel (12) zur Abdeckung der zumindest einen Ausnehmung (11A, 11B, 11C, 11D, 11E, 11F, 11G) aufweist.

4. Modulare Satelliten-Geräteträgertafel nach einem der vorhergehenden Ansprüche,
**dadurch gekennzeichnet,**
**dass** der Grundkörper (10) mit Signal- und/oder Datenübertragungsmitteln versehen ist, die im Bereich der zumindest einen Ausnehmung (11A, 11B, 11C, 11D, 11E, 11F, 11G) vorgesehene Signal- und/oder Datenübertragungsanschlüsse aufweisen.

5. Modulare Satelliten-Geräteträgertafel nach Anspruch 4,
**dadurch gekennzeichnet,**
**dass** die Signal- und/oder Datenübertragungsmittel elektrisch leitende Verbindungen aufweisen.

6. Modulare Satelliten-Geräteträgertafel nach Anspruch 4 oder 5,
**dadurch gekennzeichnet,**
**dass** die Signal- und/oder Datenübertragungsmittel optische Lichtleiterverbindungen aufweisen.

7. Modulare Satelliten-Geräteträgertafel nach einem der Ansprüche 4 bis 6,
**dadurch gekennzeichnet,**
**dass** die Signal- und/oder Datenübertragungsmittel zumindest einen Datenbus aufweisen.

8. Modulare Satelliten-Geräteträgertafel nach Anspruch 7,
**dadurch gekennzeichnet,**
**dass** der Datenbus als drahtloser Datenbus ausgebildet ist, über den in die zumindest eine Ausnehmung (11A, 11B, 11C, 11D, 11E, 11F, 11G) eingesetzte Baugruppen (2, 3, 8) miteinander oder mit einer zentralen Satelliteninfrastruktur kommunizieren.

9. Modulare Satelliten-Geräteträgertafel nach einem der vorhergehenden Ansprüche,
**dadurch gekennzeichnet,**
**dass** zumindest eine der in die Ausnehmungen (11B, 11C) des Grundkörpers (10) einsetzbaren oder eingesetzten elektrischen und/oder elektronischen Baugruppen (8) von Hochfrequenz-Elektronikkästen (80, 82) gebildet ist; dass Hochfrequenz-Koaxialkabel (81') und/oder Hochfrequenz-Wellenleiter (84, 87) zumindest teilweise in den Grundkörper (10) eingebettet sind und dass die Hochfrequenz-Elektronikkästen (80, 82) über die Hochfrequenz-Koaxialkabel (81') und/oder die Hochfrequenz-Wellenleiter (84, 87) zur Kommunikation mit entsprechenden Hochfrequenzkomponenten einer zentralen Satelliteninfrastruktur verbindbar sind.

10. Modulare Satelliten-Geräteträgertafel nach einem der vorhergehenden Ansprüche,
**dadurch gekennzeichnet,**
**dass** im Grundkörper (10) weiterhin elektrische Elemente, wie zum Beispiel Balance-Widerstände, Schalter, Sensoren, insbesondere Hall-Sensoren, Stecker und/oder Dehnungsmessstreifen eingebettet vorgesehen sind, die mit Steuer-, Versorgungs- und/oder Signalleitungen der Satelliteninfrastruktur verbindbar sind.

11. Modulare Satelliten-Geräteträgertafel nach einem der vorhergehenden Ansprüche,
**dadurch gekennzeichnet,**
**dass** die Einrichtungen zur Verteilung von elektrischer Energie, Einrichtungen zum Transport von Hochfrequenzenergie und/oder andere elektrische Versorgungsleitungen, Steuerleitungen und Signalleitungen sowie gegebenenfalls elektrische Datenübertragungsleitungen und vorzugsweise auch Heizeinrichtungen und/oder Microcontroller auf oder in zumindest einer, vorzugsweise flexiblen, Platine (56, 56') vorgesehen sind, die in den Grundkörper (10) eingebettet oder auf dem Grundkörper (10) vorgesehen ist.

12. Modulare Satelliten-Geräteträgertafel nach Anspruch 3 oder einem der Ansprüche 4 bis 11 in Kombination mit Anspruch 3,
**dadurch gekennzeichnet,**
**dass** im Deckel (12) eine, vorzugsweise flexible, Platine (6) vorgesehen ist, die Einrichtungen zur Verteilung von elektrischer Energie, Einrichtungen zum Transport von Hochfrequenzenergie und/oder andere elektrische Versorgungsleitungen, Steuerleitungen und Signalleitungen sowie gegebenenfalls elektrische Datenübertragungsleitungen und vorzugsweise auch Heizeinrichtungen und/oder Microcontroller aufweist.

13. Modulare Satelliten-Geräteträgertafel nach einem der vorhergehenden Ansprüche,
**dadurch gekennzeichnet,**
**dass** der Grundkörper (10) zumindest bereichsweise mit Wärmeleiteinrichtungen (50) ausgestattet ist, die ausgestaltet sind, um auf den Grundkörper (10) oder auf einen Bereich des Grundkörpers (10) einwirkende Wärme oder Kälte durch Wärmeleitung abzutransportieren.

14. Modulare Satelliten-Geräteträgertafel nach Anspruch 13,
**dadurch gekennzeichnet,**
**dass** die Wärmeleiteinrichtungen (50) Heatpipes aufweisen, die an oder in dem Grundkörper (10) vorgesehen sind.

15. Modulare Satelliten-Geräteträgertafel nach Anspruch 14,
**dadurch gekennzeichnet,**
**dass** die Heatpipes von im Inneren des Grundkörpers (10) verlaufenden Bahnen aus einem wärmeleitenden Material, vorzugsweise aus einem Metall, oder von im Inneren des Grundkörpers (10) verlaufenden Kanälen aus einem wärmeleitenden Material, vorzugsweise aus einem Metall, gebildet sind, die von einem Wärmetransportmedium durchströmt oder durchströmbar sind.

## Claims

1. Modular satellite equipment support panel (1) for receiving electrical and/or electronic assemblies (2, 3, 8),
**characterised in that**
- the satellite equipment support panel (1) has a base body (10) which is provided with at least one recess (11A, 11B, 11C, 11D, 11E, 11F, 11G) into which at least one of the electrical and/or electronic assemblies (2, 3, 8) can be fitted, and
- the base body (10) has devices (4) for distributing electrical energy to electrical energy connections, provided on the base of the at least one recess (11A, 11B, 11C) or on an inner end wall of the at least one recess (11D, 11E, 11F, 11G), the at least one recess (11D, 11E, 11F, 11G) being open at the top and to one side, for the at least one electrical and/or electronic assembly (2, 3, 8) provided there.

2. Modular satellite equipment support panel according to claim 1,
**characterised in that**
the devices (4) for distributing electrical energy form at least one energy bus (4A, 4B).

3. Modular satellite equipment support panel according to claim 1 or 2,
**characterised in that**
the base body (10) has at least one cover (12) for covering the at least one recess (11A, 11B, 11C, 11D, 11E, 11F, 11G).

4. Modular satellite equipment support panel according to any of the preceding claims,
**characterised in that**
the base body (10) is provided with signal and/or data transmission means which have signal and/or data transmission connections provided in the region of the at least one recess (11A, 11B, 11C, 11D, 11E, 11F, 11G).

5. Modular satellite equipment support panel according to claim 4,
**characterised in that**
the signal and/or data transmission means have electrically conductive connections.

6. Modular satellite equipment support panel according to claim 4 or 5,
**characterised in that**
the signal and/or data transmission means have optical fibre connections.

7. Modular satellite equipment support panel according to any one of claims 4 to 6,
**characterised in that**
the signal and/or data transmission means have at least one data bus.

8. Modular satellite equipment support panel according to claim 7,
**characterised in that**
the data bus is designed as a wireless data bus via which assemblies (2, 3, 8) inserted into the at least one recess (11A, 11B, 11C, 11D, 11E, 11F, 11G) communicate with one another or with a central satellite infrastructure.

9. Modular satellite equipment support panel according to any of the preceding claims,
**characterised in that**
at least one of the electrical and/or electronic assemblies (8) which can be inserted or are inserted into the recesses (11B, 11C) of the base body (10) is formed by high-frequency electronics boxes (80, 82);
high-frequency coaxial cables (81') and/or high-frequency waveguides (84, 87) are at least partially embedded in the base body (10), and
the high-frequency electronics boxes (80, 82) are connectable via the high-frequency coaxial cables (81') and/or the high-frequency waveguides (84, 87) for communication with corresponding high-frequency components of a central satellite infrastructure.

10. Modular satellite equipment support panel according to any one of the preceding claims,
**characterised in that**
electrical elements such as, for example, balance resistors, switches, sensors, in particular Hall sensors, plugs and/or strain gauges, which can be connected to control, supply and/or signal lines of the satellite infrastructure, are further provided embedded in the base body (10).

11. Modular satellite equipment support panel according to any one of the preceding claims,
**characterised in that**
the devices for distributing electrical energy, devices for transporting radio-frequency energy and/or other electrical supply lines, control lines and signal lines and, if appropriate, electrical data transmission lines and preferably also heating devices and/or microcontrollers are provided on or in at least one, preferably flexible, printed circuit board (56, 56') which is embedded in the base body (10) or is provided on the base body (10).

12. Modular satellite equipment support panel according to claim 3 or any one of claims 4 to 11 in combination with claim 3,
**characterised in that**
a, preferably flexible, circuit board (6) is provided in the cover (12), which circuit board (6) has devices for distributing electrical energy, devices for transporting radio-frequency energy and/or other electrical supply lines, control lines and signal lines and, if appropriate, electrical data transmission lines and preferably also heating devices and/or microcontrollers.

13. Modular satellite equipment support panel according to any one of the preceding claims,
**characterised in that**
the base body (10) is equipped, at least in regions, with heat-conducting devices (50) which are designed in order to transport away heat or cold acting on the base body (10) or on a region of the base body (10) by heat conduction.

14. Modular satellite equipment support panel according to claim 13,
**characterised in that**
the heat conduction devices (50) have heat pipes which are provided on or in the base body (10).

15. modular satellite equipment support panel according to claim 14,
**characterised in that**
the heat pipes are formed by paths of a heat-conducting material, preferably of a metal, extending in the interior of the base body (10) or by channels of a heat-conducting material, preferably of a metal, extending in the interior of the base body (10), through which a heat transport medium flows or can flow.

## Revendications

1. Panneau porte-équipements de satellite modulaire (1) destiné à recevoir des ensembles électriques et/ou électroniques (2, 3, 8),
**caractérisé**
- **en ce que** le panneau porte-équipements de satellite (1) comprend un corps de base (10) pourvu d'au moins un évidement (11A, 11B, 11C, 11D, 11E, 11F, 11G) dans lequel au moins un des ensembles électriques et/ou électroniques (2, 3, 8) peut être monté, et
- **en ce que** le corps de base (10) comprend des dispositifs (4) de distribution d'énergie électrique à des raccordements d'énergie électrique prévus au fond dudit au moins un évidement (11A, 11B, 11C) ou sur une paroi frontale intérieure dudit au moins un évidement (11D, 11E, 11F, 11G), ledit au moins un évidement (11D, 11E, 11F, 11G) étant ouvert vers le haut et vers un côté, pour ledit au moins un ensemble électrique et/ou électronique (2, 3, 8) qui y est prévu.

2. Panneau porte-équipements de satellite modulaire selon la revendication 1,
**caractérisé en ce que**
les dispositifs (4) de distribution d'énergie électrique forment au moins un bus d'énergie (4A, 4B).

3. Panneau porte-équipements de satellite modulaire selon la revendication 1 ou 2,
**caractérisé en ce que**
le corps de base (10) comprend au moins un couvercle (12) pour couvrir ledit au moins un évidement (11A, 11B, 11C, 11D, 11E, 11F, 11G).

4. Panneau porte-équipements de satellite modulaire selon l'une des revendications précédentes,
**caractérisé en ce que**
le corps de base (10) est pourvu de moyens de transmission de signaux et/ou de données comprenant des ports de transmission de signaux et/ou de données prévus dans la zone dudit au moins un évidement (11A, 11B, 11C, 11D, 11E, 11F, 11G).

5. Panneau porte-équipements de satellite modulaire selon la revendication 4,
**caractérisé en ce que**
les moyens de transmission de signaux et/ou de données comprennent des liaisons électriquement conductrices.

6. Panneau porte-équipements de satellite modulaire selon la revendication 4 ou 5,
**caractérisé en ce que**
les moyens de transmission de signaux et/ou de données comprennent des liaisons à fibres optiques.

7. Panneau porte-équipements de satellite modulaire selon l'une des revendications 4 à 6,
**caractérisé en ce que**
les moyens de transmission de signaux et/ou de données comprennent au moins un bus de données.

8. Panneau porte-équipements de satellite modulaire selon la revendication 7,
**caractérisé en ce que**
le bus de données est conçu comme un bus de données sans fil par lequel des ensembles (2, 3, 8) insérés dans ledit au moins un évidement (11A, 11B, 11C, 11D, 11E, 11F, 11G) communiquent entre eux ou avec une infrastructure de satellite centrale.

9. Panneau porte-équipements de satellite modulaire selon l'une des revendications précédentes,
caractérisé
en qu'au moins un des ensembles électriques et/ou électroniques (8) insérables ou insérés dans les évidements (11B, 11C) du corps de base (10) est formé de boîtiers électroniques haute fréquence (80, 82) ;
en ce que des câbles coaxiaux haute fréquence (81') et/ou des guides d'ondes haute fréquence (84, 87) sont au moins partiellement intégrés dans le corps de base (10), et en ce que les boîtiers électroniques haute fréquence (80, 82) peuvent être reliés, par l'intermédiaire des câbles coaxiaux haute fréquence (81') et/ou des guides d'ondes haute fréquence (84, 87), pour la communication avec des composants haute fréquence correspondants d'une infrastructure de satellite centrale.

10. Panneau porte-équipements de satellite modulaire selon l'une des revendications précédentes,
**caractérisé en ce que**
des éléments électriques, tels que des résistances d'équilibrage, des commutateurs, des capteurs, en particulier des capteurs à effet Hall, des connecteurs et/ou des jauges de contrainte, qui peuvent être reliés à des lignes de commande, d'alimentation et/ou de signalisation de l'infrastructure de satellite, sont en outre prévus intégrés dans le corps de base (10).

11. Panneau porte-équipements de satellite modulaire selon l'une des revendications précédentes,
**caractérisé en ce que**
les dispositifs de distribution d'énergie électrique, des dispositifs de transport d'énergie haute fréquence et/ou d'autres lignes d'alimentation électrique, lignes de commande et lignes de signalisation ainsi que, le cas échéant, des lignes de transmission de données électriques et de préférence aussi des dispositifs de chauffage et/ou des microcontrôleurs sont prévus sur ou dans au moins une carte de circuit imprimé (56, 56'), de préférence souple, qui est intégrée dans le corps de base (10) ou prévue sur le corps de base (10).

12. Panneau porte-équipements de satellite modulaire selon la revendication 3 ou l'une des revendications 4 à 11 en combinaison avec la revendication 3,
**caractérisé en ce que**
une carte de circuit imprimé (6), de préférence souple, est prévue dans le couvercle (12), laquelle comprend des dispositifs de distribution d'énergie électrique, des dispositifs de transport d'énergie haute fréquence et/ou d'autres lignes d'alimentation électrique, lignes de commande et lignes de signalisation ainsi que, le cas échéant, des lignes de transmission de données électriques et de préférence aussi des dispositifs de chauffage et/ou des microcontrôleurs.

13. Panneau porte-équipements de satellite modulaire selon l'une des revendications précédentes,
**caractérisé en ce que**
le corps de base (10) est pourvu, au moins dans certaines zones, de dispositifs de conduction thermique (50) conçus pour dissiper par conduction thermique la chaleur ou le froid agissant sur le corps de base (10) ou sur une zone du corps de base (10).

14. Panneau porte-équipements de satellite modulaire selon la revendication 13,
**caractérisé en ce que**
les dispositifs de conduction de chaleur (50) comprennent des caloducs prévus sur ou dans ledit corps de base (10).

15. Panneau porte-équipements de satellite modulaire selon la revendication 14,
**caractérisé en ce que**
les caloducs sont formés par des chemins réalisés dans un matériau conducteur de chaleur, de préférence en métal, s'étendant à l'intérieur du corps de base (10), ou par des canaux réalisés dans un matériau conducteur de chaleur, de préférence en métal, s'étendant à l'intérieur du corps de base (10), à travers lesquels s'écoule ou peut s'écouler un milieu caloporteur.
